# EUROPEAN PATENT SPECIFICATION

(11) **EP 3 010 047 B1**
(45) Date of publication and mention of the grant of the patent: **20.01.2021**
(21) Application number: 14811634.6
(22) Date of filing: 23.05.2014
(51) Int. Cl.: H01L 31/048, C09D 7/40

(54) **PRODUCTION METHOD OF A SOLAR CELL DEGRADATION CONTROL-COVER GLASS**
VERFAHREN ZUR HERSTELLUNG EINES ABDECKUNGSGLASSES ZUR UNTERDRÜCKUNG DER ABNUTZUNG EINER SOLARZELLE
PROCÉDÉ DE PRODUCTION D'UN CAPOT EN VERRE POUR SUPPRIMER UNE DÉTÉRIORATION DE CELLULE SOLAIRE

(30) Priority: 12.06.2013 JP 2013123725
(43) Date of publication of application: 20.04.2016
(73) Proprietor: Shin-Etsu Chemical Co., Ltd., Tokyo 100-0004 (JP)
(72) Inventor: INOUE, Tomohiro, Kamisu-shi Ibaraki 314-0102 (JP); FURUDATE, Manabu, Kamisu-shi Ibaraki 314-0102 (JP); EGUCHI, Yoshitsugu, Kamisu-shi Ibaraki 314-0102 (JP); KOBAYASHI, Takashi, Kamisu-shi Ibaraki 314-0102 (JP)
(74) Representative: Angerhausen, Christoph
(86) International application number: PCT/JP2014/063644
(87) International publication number: WO 2014/199798

(56) References cited:
- WO-A1-2013/001975
- WO-A1-2013/001975
- CN-A- 102 655 178
- GB-A- 2 252 332
- JP-A- 2013 080 067
- JP-A- 2013 095 944
- US-A1- 2012 073 628

## Description

### TECHNICAL FIELD

The present invention relates to the protection of a solar cell. Particularly, the invention relates to a method for preventing a performance degradation called PID especially, through an easy and inexpensive treatment of coating the cover glasses of various solar cells; a coating liquid used in such method; and a thin film formed from such coating liquid. In particular, the invention describes a production method of a solar cell degradation control-cover glass according to the preamble of claim 1. Such production methods are known from CN 102 655 178 A.

### BACKGROUND ART

Solar cells have been used more frequently as recyclable energies have been utilized more frequently. However, it has become clear in recent days that a significant degradation in power generation capacity occurs due to a phenomenon called PID (Potential Induced Degradation), especially in the case of a solar cell operated in a condition of a severe temperature / humidity. Although the cause for that remains unclear, there has been proposed a structure where the Na ions inside the cover glass diffuse internally such that a charge transfer of the cell (battery cell) is to be hindered (Non-patent document 1).

Since the cause for that is still not clear, there exists no specific measure to be taken. In fact, although various attempts have begun to be made to, for example, change a cell encapsulation agent and coat the cell itself for the purpose of protection, any of such substitutions is not easy due to the fact that the main materials of a solar cell are almost fixed. That is, in view of a cost increase due to additional production steps, there is currently almost no effective solution to PID. Moreover, in the case of a solar cell that has already been installed, it is impossible to modify the inner parts thereof, thus resulting in almost no solution.

### PRIOR ART DOCUMENT

Non-patent document 1: Professional journal of solar cell "PVeye" by Vis On Press Co., Ltd. December issue of 2012

### SUMMARY OF THE INVENTION

### Problem to be solved by the invention

The present invention was made to solve the aforementioned problem. And, it is an object of the present invention to prevent a degradation in a power generation capacity of solar cell without modifying the parts of the solar cell themselves.

### Means to solve the problem

After giving a serious consideration to the matter, the inventors of the present invention found that the insulation property on the cover glass surface can be improved; a leakage current can be controlled; and a decrease in a power generation efficiency due to PID can be prevented, by forming on either the front or back surface of the solar cell cover glass a thin film of a metal oxide that is easily curable at a temperature of about normal temperature to 120°C.

Further, it was also made clear that the effect of controlling the performance degradation of a cell could be still be partially achieved even after coating the surface of the solar cell itself. This finding was significant in terms of protecting existing solar cells, because the finding indicates that even an installed solar cell can be processed.

The production method of a solar cell degradation control-cover glass according to the invention is set forth in claim 1.

That is, the present invention is characterized in that said water-soluble compound is selected from polyhedral oligomeric silsesquioxane, an aluminum chloride, (NH4)₂ZrO(CO3)₂ and a zinc acetate.

### Effects of the invention

According to the present invention, performance degradations in various solar cell panels due to PID can be prevented through an easy and inexpensive method of forming a metal inorganic oxide thin film on a cover glass of a solar cell.

### MODE FOR CARRYING OUT THE INVENTION

### Solar cell

There are no particular restrictions on the kinds of the solar cells to which the method of the invention can be applied, as long as the solar cells are those equipped with cover glasses provided on the surfaces thereof. However, it is especially preferred that such solar cells be those obtained by stacking a cover glass, a sealing sheet, a cell and a back sheet in the order of cover glass / sealing sheet / cell / sealing sheet / back sheet.

### Formation of metal inorganic oxide thin film

As a metal oxide coating liquid that can be used to form a thin film, a coating liquid meeting the following requirements can be preferably employed.

That is, there is employed an aqueous solution of a water-soluble metal compound which is capable of forming a metal inorganic oxide thin film after being applied.

The metal species in such case are selected from silicon, aluminum, zirconium, zinc and the like.

Examples of the aqueous solution of a metal compound include aqueous solutions of the water-soluble compounds of the aforementioned metal species. Specific examples thereof include a water-soluble silicate liquid (aqueous solution of water-soluble silicate) as an SiO₂ precursor; an aluminum chloride aqueous solution as an Al₂O₃ precursor; a (NH₄)₂ZrO(CO₃)₂ aqueous solution as a ZrO₂ precursor; and a zinc acetate hydrate as a ZnO precursor.

### Form of coating liquid

As the abovementioned coating liquid, there is preferably used a type of liquid that contains the aforementioned metal compound, and contains such metal compound or metal oxide in an amount of 0.01 to 10% by mass, preferably 0.1 to 5% by mass, in terms of metal oxide. An extremely low concentration will cause the thin film to be formed extremely thin, whereas an extremely high concentration will cause the film to thicken such that the film will crack and that an insulation effect cannot be achieved thereby.

### Formation of thin film

Any conventional method can be used to apply the coating liquid to a solar cell cover glass. Specifically, a coating film can be formed on a cover glass through a dip coating method, a spin coating method, a spray coating method, a flow coating method, brush coating method, an impregnation method, a roll method, a wire bar method, a die coating method, a screen printing method, gravure printing method, an ink-jet method and the like. While the abovementioned coating liquid can be applied to the front and/or back surface(s) of a solar cell cover glass, it is more effective that the coating liquid be applied to the back surface of the cover glass. Further, the coating liquid may also be directly applied to the surface of the solar cell.

When forming a thin film by drying and curing the coated film on the cover glass, it is preferred that such treatment be performed at a temperature of from a normal temperature to 200°C for 1 to 120 min, more preferably at a temperature of normal temperature to 120°C for 5 to 60 min. An excessively low temperature for drying and curing or an excessively short period for drying and curing may lead to curing failures. Meanwhile, an excessively high temperature for drying and curing or an excessively long period for drying and curing may cause Na ions to ooze out such that the insulation function of the thin film may be impaired.

The thin film to be formed has a thickness of 10 to 700 nm, more preferably 20 to 500 nm, particularly preferably 50 to 300 nm. When the thin film is excessively thin, the insulation effect may not be exhibited. Meanwhile, when the thin film is excessively thick, breakages may occur such that the insulation effect may not be exhibited as well.

As for the thin film of the present invention, it is preferred that the cover glass exhibit a reduction (Δ) of not more than 5% in total light transmittance; and an increase of not more than 2% in haze rate, before and after the thin film is formed.

A transparency will decrease in the case where the total light transmittance drops by more than 10% (Δ) after the thin film is formed. That is, the amount of lights reaching the solar cell will decrease in such case so that a power generation efficiency may be impaired. If the haze rate increases by more than 2% after the thin film is formed, the film will become turbid such that the amount of lights reaching the solar cell will decrease due to light scattering and that the power generation efficiency may be impaired accordingly.

Working examples and comparative examples are detailed hereunder. Working examples of the invention are these wherein the water-soluble compound is selected from polyhedral oligomeric silsesquioxane, an aluminum chloride, (NH₄)₂ZrO(CO₃)₂ and a zinc acetate.

### Working examples 1 to 37, comparative examples 1 to 2

In each example, used as the coating liquid was an aqueous solution or aqueous dispersion liquid with a total solid content concentration of the following coating material for forming thin film being adjusted to 1% by mass (in terms of metal oxide). A dip coating method was used to apply each coating liquid to the front or back surface of the cover glass of the following solar cell test module, followed by drying and curing the same at 80°C for 15 min such that thin films having the thicknesses shown in Tables 1 and 2 were able to be formed on the cover glass.

### Structure of solar cell test module

As a test module, there was used a module obtained by stacking, through heat lamination, a cover glass, an EVA (ethylene-vinyl acetate copolymer) encapsulation sheet, a cell, the EVA encapsulation sheet and a back sheet in the order of cover glass / EVA encapsulation sheet / cell / EVA encapsulation sheet / back sheet, the cell being configured as four 6-inch multicrystalline silicon cells in series.

### Coating material for forming thin film

### <SiO₂ precursor, Amorphous silicate> (Working examples 1 to 6, Comparative example 2)

As a water-soluble silicate solution, there was used Shield-S (product name, silicate aqueous solution, product developed by PVC & Polymer Materials Research Center of Shin-Etsu Chemical Co., Ltd).

### <SiO₂ precursor, Silicate molecule with well-defined structure> (Working examples 7 to 12)

A component used for forming water-soluble SiO₂ was prepared as follows. That is, a PSS hydrate-octakis (tetramethylammonium) substitution product (polyhedral oligomeric silsesquioxane having Q³₈ TMA structure, by Sigma-Aldrich Corporation) was dissolved in water, followed by removing Na ions with a strong acid ion-exchange resin and then adjusting the solid content (1% by mass in terms of SiO₂) by performing dilution with a purified water.

### <Al₂O₃ precursor> (Working examples 13 to 18)

An aqueous solution of a water-soluble aluminum salt used was prepared as follows. That is, ALFINE 83 (product name, 23% aqueous solution of highly basic aluminum chloride, by Taimei Chemicals Co., Ltd.) was diluted with a purified water to adjust the solid content (1% by mass in terms of Al₂O₃).

### <ZrO₂ precursor> (Working examples 19 to 24)

An aqueous solution of a water-soluble zirconium salt used was prepared as follows. That is, Zircosol AC-20 (product name, (NH₄)₂ZrO (CO₃)₂, aqueous solution of zirconium compound, by DAIICHI KIGENSO KAGAKU KOGYO Co., Ltd.) was diluted with a purified water to adjust the solid content (1% by mass in terms of ZrO₂).

### <Aqueous dispersion liquid of SnO₂ ultrafine particles> (Working examples 25 to 30)

SnO₂ fine particles used were prepared by adjusting the concentration (1% by mass in terms of SnO₂) of an ultrafine particles of Tin (IV) oxide sol (average primary particle diameter 5 nm, by Yamanaka & Co., Ltd) with a purified water. The aqueous dispersion liquid thus obtained exhibited a dispersion particle diameter D50 of 50 nm.

### <ZnO precursor> (Working examples 31 to 36)

A commercially available zinc acetate dihydrate was hydrolyzed with an aqueous solution of water / ethanol + triethanolamine in a manner such that the concentration thereof became 1% by mass in terms of zinc oxide. The hydrolyzed product was used immediately thereafter.

### <Aqueous dispersion liquid of SiO₂ fine particles (large)> (Comparative example 1)

An aqueous dispersion liquid of SiO₂ fine particles used was prepared by diluting SNOWTEX ST-OUP (product name, a colloidal silica having an average primary particle diameter of 100 nm, by NISSAN CHEMICAL INDUSTRIES, LTD) with a purified water such that the concentration thereof could be adjusted (1% by mass in terms of SiO₂). The aqueous dispersion liquid thus obtained exhibited a dispersion particle diameter D50 of 100 nm.

### <Aqueous dispersion liquid of SiO₂ fine particles (small)> (Working example 37)

An aqueous dispersion liquid of SiO₂ fine particles used was prepared by diluting SNOWTEX ST-NXS (product name, particle diameter 4 to 6 nm, a colloidal silica having an average primary particle diameter of 5 nm, by NISSAN CHEMICAL INDUSTRIES, LTD) with a purified water such that the concentration thereof could be adjusted (1% by mass in terms of SiO₂). The aqueous dispersion liquid thus obtained exhibited a dispersion particle diameter D50 of 5 nm.

### Method of thin film property evaluation

The film thickness of the thin film was measured by a thin film measurement system F-20 (product name, by FILMETRICS) and a scanning electron microscope S-3400 nm (product name, by Hitachi High-Technologies Corporation).

The total light transmittance and haze rate of the thin film were measured by a digital hazemeter NDH-20D (by NIPPON DENSHOKU INDUSTRIES Co., LTD).

As for an environment for promoting PID of the solar cell, the solar cell was exposed for 96 hours to an environment of temperature 60°C / humidity 85% RH / water-filled surface, with a test voltage of -1,000 Vdc being applied thereto [frame potential as reference, -1,000 Vdc to internal circuit].

As for the properties of the solar cell, a prescribed device (I-V curve tracer MP160 by EKO Instruments) was used to measure an I-V property thereof, and an EL image inspection device (PVX-300 by ITES Co., Ltd) was used for measurement as well.

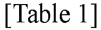

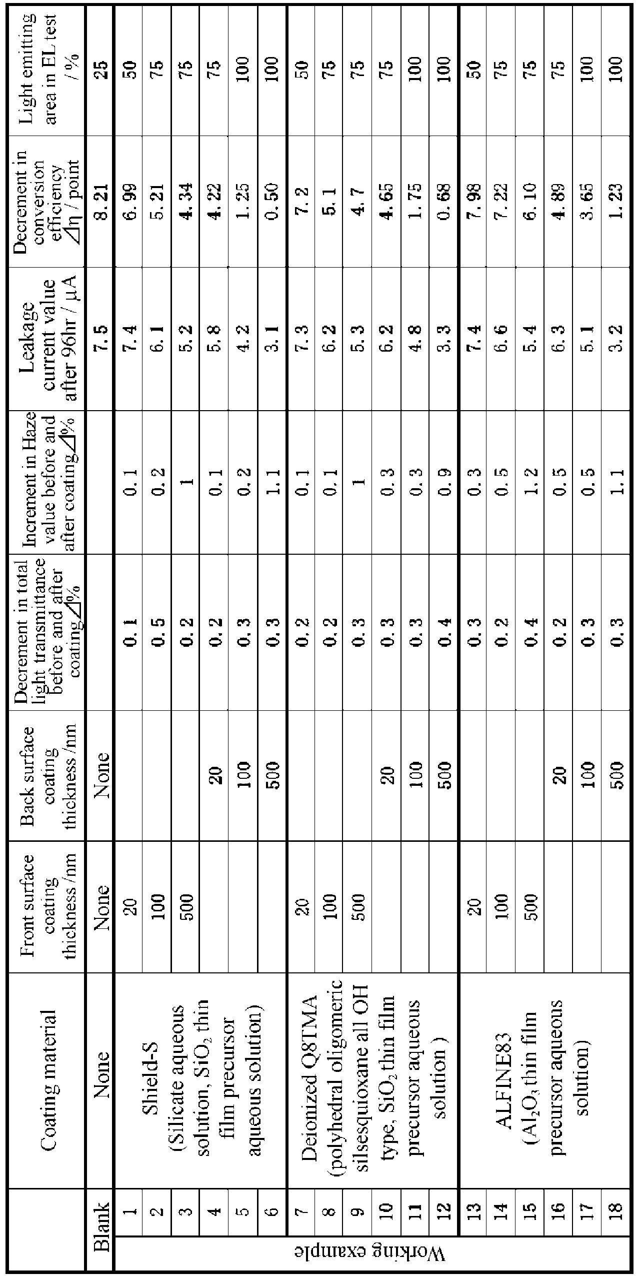

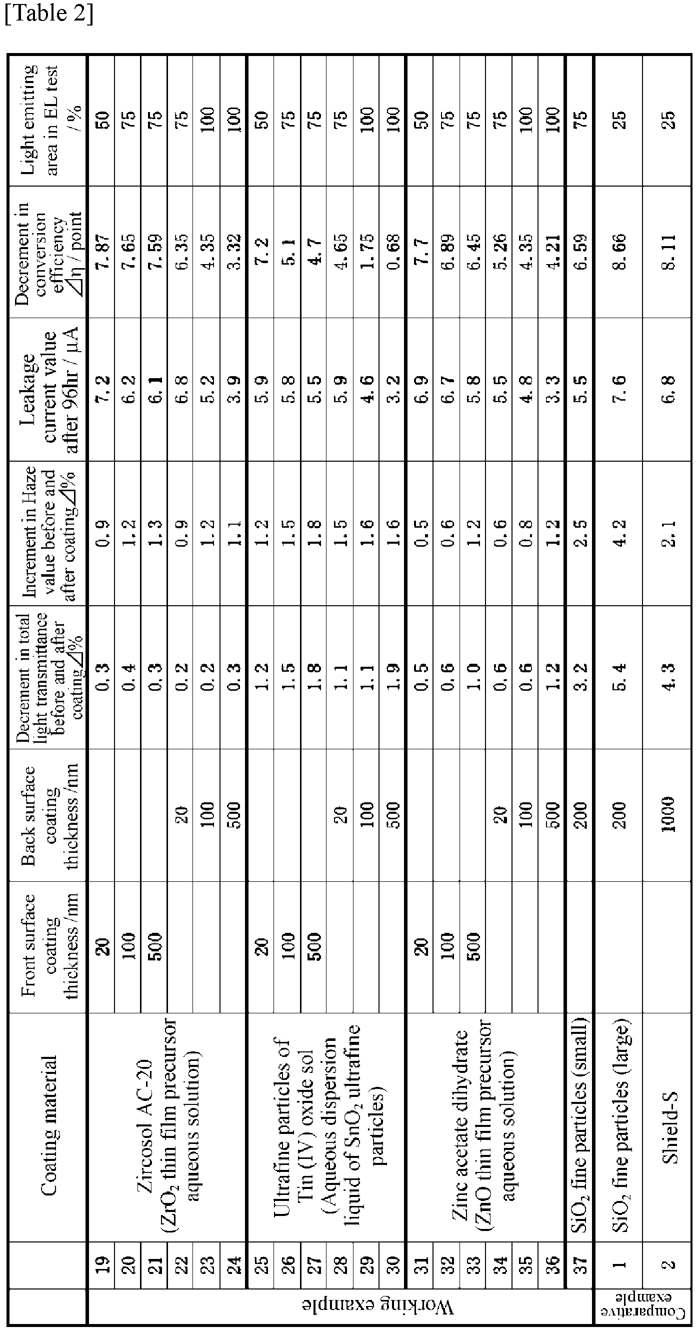

According to the results shown in Tables 1 and 2, performance degradations were able to be controlled in the solar cells with various metal oxide films of the working examples being formed thereon. In contrast, significant performance degradations were observed in the blank solar cells.

In the working examples, although no significant difference in leakage current value was confirmed as a result of coating the surface of the cover glass, it was shown through EL image determination that a light emitting capability had still existed, and a decrease in a conversion efficiency was also able to be controlled in such case. This indicates that PID can still be alleviated even after processing the cover panel surface of a solar cell that had already been processed, which is significant.

In the working examples, as a result of coating the back surface of the cover glass, not only the leakage current value dropped by half or more, but multiple cells were also confirmed to still possess the light emitting capabilities through EL image inspection i.e. an obvious degradation control was exhibited.

It can be learnt that the insulation effect and the degradation control effect can be achieved with the thin film of the Working example 37 where a dispersion liquid of small fine particles was used. In contrast, no expected effect was achieved with the thin film of the Comparative example 1 due to the fact that large particles were employed. It is considered that the reason that an insufficient degradation control effect was achieved was because the particles used were large and thus had led to a low density of the thin film.

In the Comparative example 2, tests were performed by forming a SiO₂-based thin film to a thickness of 1 micron (1,000 nm). An inorganic film having a thickness of 1 micron is extremely hard such that cracks will easily occur in a normal work environment. The occurrence of the cracks can be determined based on a significant degradation in optical property. It is considered that the reason that an insufficient degradation control effect was achieved was because such cracks had led to an insufficient density of the inorganic film.

## Claims

1. A production method of a solar cell degradation control-cover glass, said solar cell degradation control-cover glass having a front surface and a back surface that is to contact a solar cell when covering the solar cell, the production method comprising:
preparing a solar cell degradation control-coating liquid, using an aqueous solution of a water-soluble compound of at least one metal selected from silicon, aluminum, zirconium and zinc; and
applying the solar cell degradation control-coating liquid to the back surface of the solar cell degradation control-cover glass by forming a thin film on the cover glass, the thin film having a thickness of 10 to 700 nm,
wherein said aqueous solution contains said compound in an amount of 0.01 to 10% by mass in terms of metal oxide of the at least one metal, **characterized in that** said water-soluble compound is selected from polyhedral oligomeric silsesquioxane, an aluminum chloride, (NH₄)₂ZrO(CO₃)₂ and a zinc acetate.

2. The production method of the solar cell degradation control-cover glass according to claim 1, wherein the step of forming said solar cell degradation control-thin film includes an operation of drying and curing a coated film at a temperature of from a normal temperature to 200°C.

## Patentansprüche

1. Verfahren zur Herstellung eines Solarzellen-Degradationskontroll-Abdeckglases, wobei das Solarzellen-Degradationskontroll-Abdeckglas eine vordere Oberfläche und eine hintere Oberfläche aufweist, die eine Solarzelle berühren soll, wenn sie die Solarzelle bedeckt, wobei das Herstellungsverfahren aufweist:
Herstellen einer Solarzellen-Degradationskontroll-Beschichtungsflüssigkeit unter Verwendung einer wässrigen Lösung einer wasserlöslichen Verbindung von mindestens einem Metall, ausgewählt aus Silizium, Aluminium, Zirkonium und Zink; und
Aufbringen der Solarzellen-Degradationskontroll-Beschichtungsflüssigkeit auf die Rückseite des Solarzellen-Degradationskontroll-Abdeckglases durch Ausbilden eines dünnen Films auf dem Abdeckglas, wobei der dünne Film eine Dicke von 10 bis 700 nm aufweist,
wobei die wässrige Lösung die Verbindung in einer Menge von 0,01 bis 10 Masse-%, bezüglich des Metalloxids des mindestens einen Metalls, enthält, **dadurch gekennzeichnet, dass** die wasserlösliche Verbindung ausgewählt ist aus polyedrischem oligomerem Silsesquioxan, einem Aluminiumchlorid, (NH₄)₂ZrO(CO₃)₂ und einem Zinkacetat.

2. Verfahren zur Herstellung des Solarzellen-Degradationskontroll-Abdeckglases nach Anspruch 1, wobei das Ausbilden des dünnen Films zur Kontrolle der Degradation von Solarzellen einen Vorgang des Trocknens und des Härtens eines beschichteten Films bei einer Temperatur von einer Normaltemperatur bis 200°C einschließt.

## Revendications

1. Procédé de production d'un verre protecteur pour réguler la dégradation de cellules solaires, ledit verre protecteur pour réguler la dégradation de cellules solaires ayant une surface recto et une surface verso qui est destinée à venir au contact d'une cellule solaire lors du revêtement de la cellule solaire, le procédé de production comprenant :
la préparation d'un liquide de revêtement pour réguler la dégradation de cellules solaires, utilisant une solution aqueuse d'un composé soluble dans l'eau d'au moins un métal choisi parmi le silicium, l'aluminium, le zirconium et le zinc ; et
l'application du liquide de revêtement pour réguler la dégradation de cellules solaires sur la surface verso du verre protecteur pour réguler la dégradation de cellules solaires par formation d'un film mince sur le verre protecteur, le film mince ayant une épaisseur de 10 à 700 nm,
dans lequel ladite solution aqueuse contient ledit composé en une quantité de 0,01 à 10 % en masse en termes d'oxyde métallique de l'au moins un métal, **caractérisé en ce que** ledit composé soluble dans l'eau est choisi parmi le silsesquioxane oligomère polyédrique, le chlorure d'aluminium, (NH₄)₂ZrO(CO₃)₂ et l'acétate de zinc.

2. Procédé de production d'un verre protecteur pour réguler la dégradation de cellules solaires selon la revendication 1, dans lequel ladite étape de formation dudit film mince pour réguler la dégradation de cellules solaires comprend une opération de séchage et de durcissement d'un film déposé sous forme de revêtement à une température allant de la température normale à 200°C.
